# EUROPÄISCHE PATENTSCHRIFT

(11) **EP 3 840 554 B1**
(45) Veröffentlichungstag und Bekanntmachung des Hinweises auf die Patenterteilung: **22.05.2024**
(21) Anmeldenummer: 20213655.2
(22) Anmeldetag: 14.12.2020
(51) Int. Cl.: H05K 7/14

(54) **ELEKTRISCHE EINRICHTUNG UND ANORDNUNG MIT EINER ELEKTRISCHEN MASCHINE UND EINER ELEKTRISCHEN EINRICHTUNG**
ELECTRICAL DEVICE AND ASSEMBLY COMPRISING AN ELECTRIC MACHINE AND AN ELECTRICAL DEVICE
DISPOSITIF ÉLECTRIQUE ET AGENCEMENT DOTÉ D'UNE MACHINE ÉLECTRIQUE ET D'UN DISPOSITIF ÉLECTRIQUE

(30) Priorität: 19.12.2019 DE 102019135137
(43) Veröffentlichungstag der Anmeldung: 23.06.2021
(73) Patentinhaber: Valeo eAutomotive Germany GmbH, 91056 Erlangen (DE)
(72) Erfinder: BOTHOR, Christof, 90537 Feucht (DE); ROEDER, Frank, 04317 Leipzig (DE); HOYLER, Christoph, 91241 Kirchensittenbach (DE); REYMANN, Markus, 90451 Nürnberg (DE); TILP, Michael, 90402 Nürnberg (DE)

(56) Entgegenhaltungen:
- JP-A- 2014 180 079
- US-A1- 2007 115 707
- US-B1- 10 027 070

## Beschreibung

Die vorliegende Erfindung betrifft eine elektrische Einrichtung. Daneben betrifft die Erfindung eine Anordnung mit einer elektrischen Maschine und einer elektrischen Einrichtung sowie ein Fahrzeug.

Bei elektrischen Einrichtungen mit einem Gehäuse, in dessen Aufnahmeraum elektrische Komponenten der elektrischen Anordnung angeordnet sind, sind häufig Sensoreinheiten vorgesehen, um zu detektieren, ob eine den Aufnahmeraum in einer ersten Position verschließende Abdeckvorrichtung in eine einen Zugriff auf den Aufnahmeraum erlaubende zweiten Position der Abdeckvorrichtung überführt wird. Entsprechende Detektionssignale können von einer Interlockschaltung ausgewertet werden, welche die Komponenten spannungsfrei schaltet, um einen elektrischen Schlag bei einem unbeabsichtigten oder unbefugten Zugriff auf die unter elektrischer Spannung stehenden Komponenten zu verhindern. Neben mechanischen Kontakten, die in der ersten Position geschlossen und in der zweiten Position getrennt sind, wurde bereits vorgeschlagen, eine Detektion des Entfernens der Abdeckvorrichtung durch eine Sensoreinheit mit einem Magnetelement und einem Magnetsensor zu realisieren.

JP 2014 180079 A, US 2007/115707 A1 und US 10 027 070 B1 sind bekannte Verriegelungssytem nach dem Stand der Technik. Das Dokument EP 2 624 370 B1 offenbart beispielsweise einen elektrischen Verbinder, der dazu bestimmt ist, eine elektrische Verbindung zwischen wenigstens einem elektrischen Leiter und einer elektrischen Schaltung herzustellen und folgendes umfasst: eine Anschlussplatte zwischen dem Leiter und der elektrischen Schaltung, eine Abdeckung, die dazu bestimmt ist, die Platte abzudecken, um einen im Wesentlichen geschlossenen Raum zu definieren, und Stromunterbrechungsmittel, die dazu bestimmt sind einen in der Platte fließenden Strom zu unterbrechen, wenn ein Abstand zwischen der Platte und der Abdeckung größer als ein vorgegebener Wert ist. Dazu weist das Stromunterbrechungsmittel einen Hall-Effekt-Sensor auf, der ein von einer magnetischen Oberfläche ausgesendetes Signal detektiert, wobei der Sensor an der Anschlussplatte positioniert ist und die magnetische Oberfläche an der Abdeckung positioniert ist oder umgekehrt.

Wenn bei einer solchen Einrichtung ein Zugriff auf den Aufnahmeraum, beispielsweise zu Wartungszwecken erfolgen soll, muss die gesamte Abdeckvorrichtung entfernt werden. Dies ist arbeitsaufwendig und erschwert die Wartung der elektrischen Einrichtung.

Der Erfindung liegt mithin die Aufgabe zugrunde, eine wartungsfreundliche elektrische Einrichtung mit einer Detektionsmöglichkeit für einen unbeabsichtigten oder unbefugten Zugriff auf den Aufnahmeraum anzugeben.

Diese Aufgabe wird erfindungsgemäß durch eine elektrische Einrichtung gelöst, umfassend ein Gehäuse mit einem Aufnahmeraum, in dem elektrische Komponenten der Einrichtung angeordnet sind; eine Abdeckvorrichtung mit einem ersten Abdeckelement und einem zweiten Abdeckelement, wobei das erste Abdeckelement eine Ausnehmung aufweist und das zweite Abdeckelement bezüglich des ersten Abdeckelements derart anordenbar ist, dass das zweite Abdeckelement in einer ersten Stellung die Ausnehmung verdeckt und in einer zweiten Stellung einen Zugriff auf die Ausnehmung ermöglicht, wobei die Abdeckvorrichtung bezüglich des Gehäuses derart anordenbar ist, dass die Abdeckvorrichtung in einer ersten Position den Aufnahmeraum verschließt, wenn das zweite Abdeckelement in der ersten Stellung ist, und einen Zugriff auf einen ersten Teilaufnahmeraum des Aufnahmeraums durch die Ausnehmung ermöglicht und einen zweiten Teilaufnahmeraum des Aufnahmeraums verschließt, wenn das zweite Abdeckelement in der zweiten Stellung ist, und dass die Abdeckvorrichtung in einer zweiten Position einen Zugriff auf den ersten Teilaufnahmeraum und den zweiten Teilaufnahmeraum ermöglicht; und eine Sensoreinheit mit einem Magnetelement und einem Magnetsensor, der dazu eingerichtet ist, beim Detektieren einer Abwesenheit des Magnetelements ein Detektionssignal bereitzustellen, wobei die Sensoreinheit zum Detektieren der Abwesenheit des Magnetelements in der zweiten Stellung des zweiten Abdeckelements und in der zweiten Position der Abdeckvorrichtung angeordnet und ausgebildet ist.

Der Erfindung liegt die Überlegung zugrunde, den Aufnahmeraum in zwei Teilaufnahmeräume zu gliedern, wobei im ersten Teilaufnahmeraum wartungsintensive Komponenten und im zweiten Teilaufnahmeraum weniger wartungsintensive bzw. wartungsarme Komponenten angeordnet werden können. Zusätzlich wird die Abdeckvorrichtung durch zwei Abdeckelemente ausgebildet, wobei das zweite Abdeckelement in der zweiten Stellung im Wesentlichen nur einen Zugriff auf den ersten Teilaufnahmeraum durch die Ausnehmung im ersten Abdeckelement ermöglicht. Für einen Zugriff auf den ersten Aufnahmeraum ist daher nicht die Entfernung der gesamten Abdeckvorrichtung erforderlich, sondern nur des kleineren zweiten Abdeckelements. Dabei ist die Sensoreinheit so angeordnet, dass sie sowohl in der zweiten Stellung des zweiten Abdeckelements als auch in der zweiten Position der Abdeckvorrichtung, in der ein Zugriff auf den gesamten Aufnahmeraum ermöglicht ist, ein, beispielsweise durch eine Interlockschaltung auswertbares, Detektionssignal bereitstellt. Die magnetische Sensoreinheit ermöglicht dabei eine kontaktlose Detektion, ohne dass eine elektrische Leitung für die Detektion des Entfernens des zweiten Abdeckelements durch das erste Abdeckelement hindurchgeführt werden muss.

Die erfindungsgemäße Einrichtung erlaubt es mithin, einen Zugriff auf den ersten Teilaufnahmeraum nur durch Entfernen des zweiten Abdeckelements zu erhalten, was die Wartungsfreundlichkeit durch das Einsparen von Arbeitsschritten erhöht. Gleichsam ist durch die Sensoreinheit eine aufwandsarme Detektionsmöglichkeit für einen unbeabsichtigten oder unbefugten Zugriff auf den Aufnahmeraum gegeben.

Es wird bei der erfindungsgemäßen Einrichtung bevorzugt, wenn das Magnetelement an dem oder im zweiten Abdeckelement angeordnet ist. Dadurch kann die Abwesenheit des Magnetelements sowohl bei einer bloßen Entfernung des zweiten Abdeckelements als auch eine Entfernung der gesamten Abdeckvorrichtung erfasst werden.

Es ist bei der erfindungsgemäßen Einrichtung ferner von Vorteil, wenn die Sensoreinheit derart ausgebildet ist, dass mittels des Magnetsensors eine Feldstärke des das erste Abdeckelement durchdringenden Magnetfelds des Magnetelements in der ersten Stellung des zweiten Abdeckelements als Anwesenheit des Magnetelements erfassbar ist. Dadurch kann die Abwesenheit des Magnetelements anhand des von ihm erzeugten Magnetfelds kontaktlos durch das erste Abdeckelement hindurch detektiert werden.

In bevorzugter Ausgestaltung der erfindungsgemäßen Einrichtung ist ferner vorgesehen, dass das erste Abdeckelement eine zum Aufnahmeraum weisende Eintiefung aufweist, in welcher sich das Magnetelement in der ersten Stellung des zweiten Abdeckelements befindet. Dadurch kann vorteilhafterweise eine ordnungsgemäße Positionierung des Magnetelements im Bezug auf den Magnetsensor realisiert werden und eine Anordnung der Komponenten innerhalb des Aufnahmeraums flexibel gestaltet werden. Das zweite Abdeckelement kann einen Vorsprung aufweisen, welcher in der ersten Stellung des zweiten Abdeckelements in die Eintiefung eingreift.

Grundsätzlich ist es bei der erfindungsgemäßen Einrichtung bevorzugt, wenn der Magnetsensor im Aufnahmeraum angeordnet ist. Dadurch kann auf eine elektrische Verkabelung des Magnetsensors außerhalb des Aufnahmeraums verzichtet werden. Besonders bevorzugt ist der Magnetsensor im zweiten Aufnahmeraum angeordnet. Dies hat den Vorteil, dass ein Zugriff auf den Magnetsensor durch die Abdeckung und damit auch dessen Manipulation erschwert wird.

Es ist allerdings dennoch denkbar, dass bei der erfindungsgemäßen Einrichtung vorgesehen ist, dass der Magnetsensor an dem oder im zweiten Abdeckelement angeordnet ist. Dann kann das Magnetelement im Aufnahmeraum, vorzugsweise im zweiten Teilaufnahmeraum, angeordnet sein. Insoweit kann auch vorgesehen sein, dass das erste Abdeckelement eine zum Aufnahmeraum weisende Eintiefung aufweist, in welchem sich der Magnetsensor in der ersten Stellung des zweiten Abdeckelements befindet.

Die Wartungsfreundlichkeit der erfindungsgemäßen Einrichtung kann ferner verbessert werden, wenn im ersten Teilaufnahmeraum ein Befestigungsmittel zur lösbaren Befestigung einer der elektrischen Komponenten, vorzugsweise einer Sicherung, angeordnet ist. Gerade Sicherungen sind ein gutes Beispiel für die eingangs erwähnten wartungsintensiven elektrischen Komponenten.

Die erfindungsgemäße Einrichtung kann ferner ein Dichtelement umfassen, welches zum Abdichten des Gehäuses gegenüber dem ersten Abdeckelement ausgebildet ist. Durch das Dichtelement, welches auch als erstes Dichtelement bezeichnet werden kann, lässt sich beispielsweise eine gewünschte IP-Schutzklasse der Einrichtung erzielen. Dabei wird es bevorzugt, wenn das Dichtelement nicht zerstörungsfrei aus der ersten Position in die zweite Position überführbar ist. Als erstes Dichtelement ist beispielsweise eine Klebedichtung vorgesehen sein, welche vorteilhafterweise wirkungsvoll und kostengünstig ein hohen Schutz vor einem Eindringen von Wasser und/oder Staub in den Aufnahmeraum ermöglicht. Da das erste Abdeckelement im Wesentlichen den zweiten Teilaufnahmeraum abdeckt, welcher für weniger wartungsintensive elektrisch Komponenten vorgesehen ist, beeinträchtigt die fehlende Reversibilität des ersten Dichtelements die Wartung der wartungsintensiveren Komponenten im ersten Teilaufnahmebereich praktisch nicht.

Die erfindungsgemäße Einrichtung kann ferner ein Dichtelement umfassen, welches zum Abdichten des ersten Abdeckelements gegenüber dem zweiten Abdeckelement ausgebildet ist. Dadurch kann die gewünschte IP-Schutzklasse auch im Hinblick auf die beiden Abdeckelemente realisiert werden. Vorzugsweise ist dieses, auch als zweites Dichtelement zu bezeichnende, Dichtelemente zerstörungsfrei aus der ersten Stellung des zweiten Abdeckelements in dessen zweite Stellung überführbar. Dafür bietet sich beispielsweise die Verwendung einer Silikondichtung oder eines O-Rings an. Das zweite Dichtelement ist zweckmäßigerweise am ersten Abdeckelement und nicht am zweiten Abdeckelement befestigt oder am zweiten Abdeckelement und nicht am ersten Abdeckelement befestigt. Typischerweise erstreckt sich das Dichtelement entlang eines Rands des Ausnehmung, wenn sich das zweite Abdeckelement in der ersten Stellung befindet. Alternativ kann sich das Dichtelement entlang einer Außenkontur des zweiten Abdeckelements erstrecken. Es kann ein weiteres Dichtelement vorgesehen sein, welches sich um das am zweiten Abdeckelement angeordnete Magnetelement oder um den am zweiten Abdeckelement angeordneten Magnetsensor erstreckt. Dadurch kann das Magnetelement beispielweise vor Korrosion geschützt werden.

Es ist insofern anzumerken, dass der Dichtbereich des ersten Dichtelements, welches weniger aufwendig als das zweite Dichtelement ausgebildet werden kann, wesentlich größer als ein Dichtbereich des zweiten Dichtelements ist, welches typischerweise aufwendiger ausgebildet und kostenintensiver ist.

Grundsätzlich wird es dabei bevorzugt, wenn das Magnetelement und der Magnetsensor außerhalb eines Dichtbereichs des zweiten Dichtelements angeordnet sind.

Um den hohen Sicherheitsanforderungen bei einem automotiven Einsatz der erfindungsgemäßen Einrichtung gerecht zu werden, kann vorgesehen sein, dass die Sensoreinheit ferner einen redundanten Magnetsensor aufweist, welcher dazu eingerichtet ist, beim Detektieren der Abwesenheit des Magnetelements ein weiteres Detektionssignal bereitzustellen. Durch diese Redundanz kann ein hohes Sicherheitsniveau, beispielsweise ASIL B, erzielt werden.

Zweckmäßigerweise umfasst die erfindungsgemäße Einrichtung ferner eine Interlockschaltung, welche dazu eingerichtet ist, die elektrischen Komponenten in Abhängigkeit des Detektionssignals oder der Detektionssingale spannungsfrei zu schalten. Die Interlockschaltung kann beispielsweise eine Steuereinheit aufweisen, welche dazu eingerichtet ist, das Detektionssignal oder die Detektionssignale auszuwerten. Daneben kann die Interlockschaltung eine Schalteinheit aufweisen, welche dazu eingerichtet ist, eine elektrische Verbindung zu den elektrischen Komponenten in Abhängigkeit des Detektionssignals oder der Detektionssingale spannungsfrei zu schalten.

Es kann vorgesehen sein, dass die Sensoreinheit eine Signalverarbeitung umfasst welche Rohinformationen des Magnetsensors auswertet und ein konditioniertes Detektionssignal bereitstellt. Es kann jedoch auch vorgesehen sein, die Sensoreinheit dazu eingerichtet ist, Rohdaten als Detektionssignals bereitzustellen, welche mittels einer Signalverarbeitung der Interlockschaltung auswertbar sind.

Bei der Interlockschaltung kann ferner vorgesehen sein, dass diese eine Leitungsüberwachung für eine eine Versorgungsspannung der Sensoreinheit führende Leitung aufweist und dazu eingerichtet ist, die elektrischen Komponenten in Abhängigkeit eines eine Unterbrechung der Versorgungsspannung anzeigenden Überwachungssignals der Leitungsüberwachung spannungsfrei zu schalten. Durch eine solche Leitungsüberwachung kann beispielsweise auf den redundanten Magnetsensor verzichtet werden, ohne das Sicherheitsniveau zu verringen, weil insoweit ein Ausfall des Magnetsensors detektierbar ist.

In vorteilhafter Ausgestaltung ist die erfindungsgemäße Einrichtung als Wechselrichter ausgebildet.

Die der Erfindung zugrunde liegende Aufgabe wird ferner durch eine Anordnung mit einer elektrischen Maschine und einer erfindungsgemäßen Einrichtung gelöst, wobei der Stromrichter dazu eingerichtet ist, eine ein- oder mehrphasige Wechselspannung für die elektrische Maschine bereitzustellen. Vorteilhafterweise ist vorgesehen, dass die elektrische Maschine zum Antreiben eines elektrisch antreibbaren Fahrzeugs eingerichtet ist.

Die der Erfindung zugrunde liegende Aufgabe wird auch durch ein Fahrzeug, umfassend eine erfindungsgemäße elektrische Einrichtung oder eine erfindungsgemäße Anordnung, gelöst.

Weitere Vorteile und Einzelheiten der vorliegenden Erfindung ergeben sich aus den im Folgenden beschriebenen Ausführungsbeispielen sowie anhand der Zeichnungen. Diese sind schematische Darstellungen und zeigen:
- Fig. 1: eine perspektivische geschnittene Ansicht eines Ausführungsbeispiels der erfindungsgemäßen elektrischen Einrichtung;
- Fig. 2: eine perspektivische geschnittene Detailansicht des Ausführungsbeispiels im Bereich der Sensoreinheit;
- Fig. 3: eine perspektivische Ansicht des zweiten Abdeckelements gemäß dem Ausführungsbeispiel;
- Fig. 4: ein Blockschaltbild der Interlockschaltung gemäß dem Ausführungsbeispiel; und
- Fig. 5: eine Prinzipskizze eines Ausführungsbeispiels des erfindungsgemäßen Fahrzeugs mit der erfindungsgemäßen Anordnung.

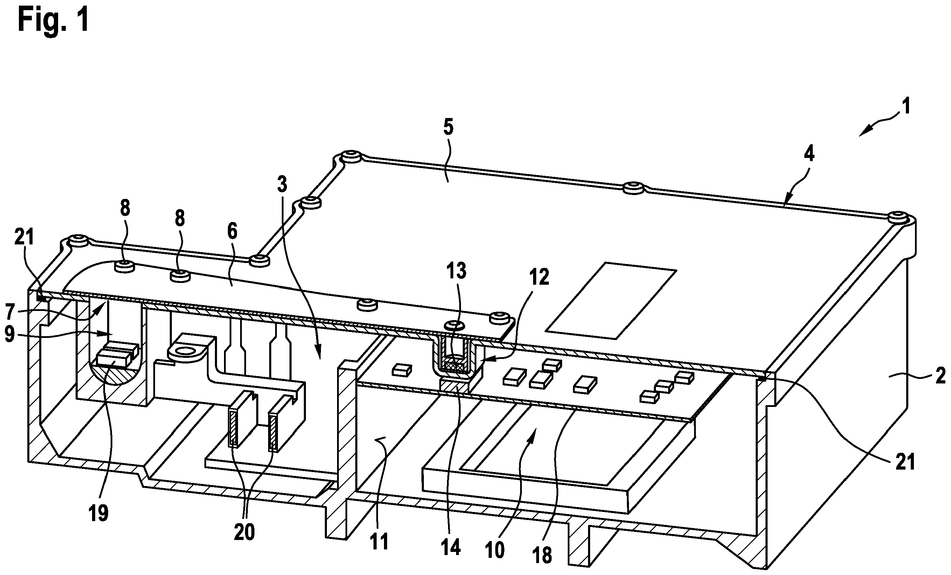

Fig. 1 ist eine perspektivische geschnittene Ansicht eines Ausführungsbeispiels einer elektrischen Einrichtung 1.

Die elektrische Einrichtung 1 umfasst ein Gehäuse 2 mit einem Aufnahmeraum 3, in dem elektrische Komponenten der Einrichtung 1 angeordnet sind. Daneben umfasst die Einrichtung 1 eine Abdeckvorrichtung 4, die ein erstes Abdeckelement 5 und ein zweites Abdeckelement 6 aufweist. Das erste Abdeckelement 5 weist eine Ausnehmung 7 auf. Das zweite Abdeckelement 6 ist bezüglich des ersten Abdeckelements 5 derart anordenbar, dass das zweite Abdeckelement in einer - in Fig. 1 gezeigten - ersten Stellung die Ausnehmung 7 verdeckt und in einer zweiten Stellung einen Zugriff auf die Ausnehmung 7 ermöglicht. In der zweiten Stellung ist das zweite Abdeckelement 6, beispielsweise nach Entfernen von Befestigungsmitteln 8, vom ersten Abdeckelement 5 abgenommen, sodass die Ausnehmung 7 offenliegt.

Die Abdeckvorrichtung 4 selbst ist bezüglich des Gehäuses 2 derart anordenbar, dass sie in einer - in Fig. 1 gezeigten - ersten Position den Aufnahmeraum 3 verschließt, wenn das zweite Abdeckelement 6 in der ersten Stellung ist. Befindet sich hingegen das zweite Abdeckelement 6 in der zweiten Stellung und die Abdeckvorrichtung 4 in der ersten Position, so ist ein Zugriff auf einen ersten Teilaufnahmeraum 9 durch die Ausnehmung 7 im ersten Abdeckelement 5 möglich und ein zweiter Teilaufnahmeraum 10 verschlossen. Die Abdeckvorrichtung 4 ist ferner derart anordenbar, dass sie in einer zweiten Position, die grundsätzlich unabhängig von der Stellung des zweiten Abdeckelements 6 ist, einen Zugriff auf den ersten Teilnahmeraum 9 und den zweiten Teilaufnahmeraum 10 ermöglicht.

Es ist insofern darauf hinzuweisen, dass die Teilaufnahmeräume 9, 10 im vorliegenden Ausführungsbeispiel den gesamten Aufnahmeraum 3 ausbilden, auch wenn der zweite Teilaufnahmeraum 10 beispielsweise durch eine Innenwand 11 des Gehäuses 2 räumlich weiter untergliedert ist.

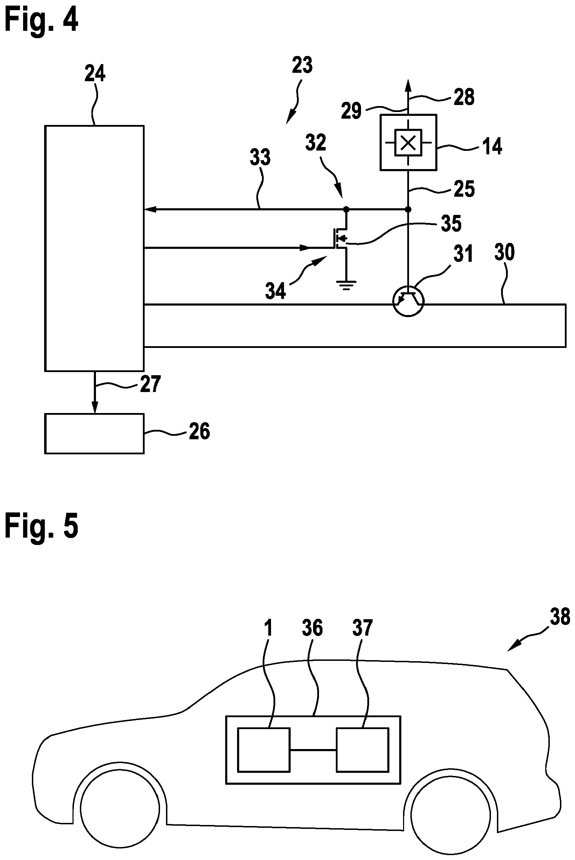

Daneben umfasst die elektrische Einrichtung 1 eine Sensoreinheit 12 mit einem Magnetelement 13 und einem Magnetsensor 14, der dazu eingerichtet ist, beim Detektieren einer Abwesenheit des Magnetelements 13 ein Detektionssignal 25 (siehe Fig. 4) bereitzustellen. Die Sensoreinheit ist dabei derart angeordnet und ausgebildet, dass die Abwesenheit des Magnetelements 13 in der zweiten Stellung des zweiten Abdeckelements 6 und in der zweiten Position der Abdeckvorrichtung 4 detektierbar ist.

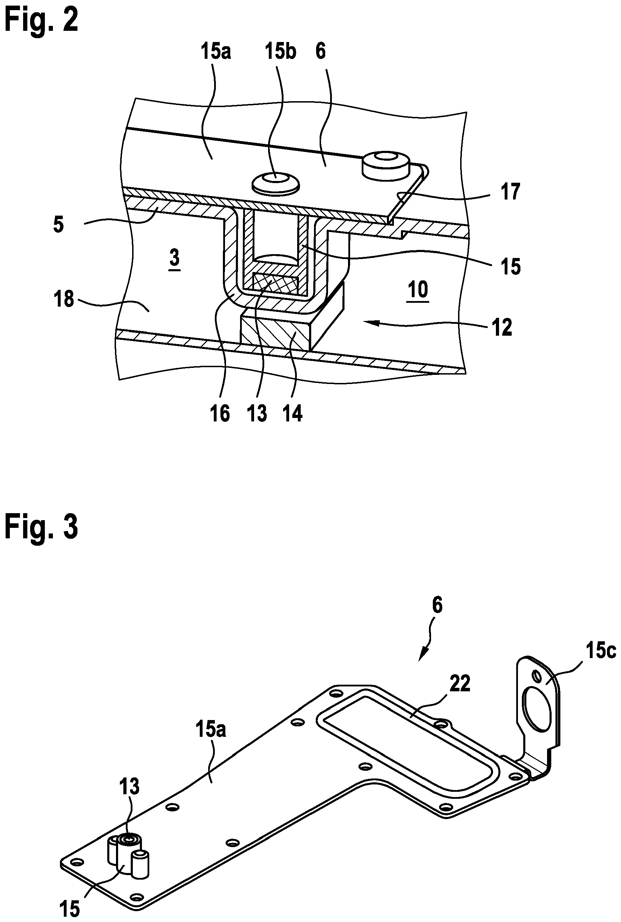

Fig. 2 zeigt dazu einen geschnittene Detailansicht der Einrichtung 1 gemäß dem Ausführungsbeispiel im Bereich der Sensoreinheit 12.

Das Magnetelement 13 ist vorliegend als Permanentmagnet ausgebildet und an einem Vorsprung 15 des zweiten Abdeckelements 6 angeordnet. Das Magnetelement 13 ist dabei randseitig vom Vorsprung 15 eingefasst, wobei es alternativ auch möglich ist, dass das Magnetelement 13 vollständig durch den Vorsprung 15 eingefasst oder anderweitig in das zweite Abdeckelement 6 integriert und somit im zweiten Abdeckelement 6 angeordnet ist. Es ist auch denkbar, dass Magnetelement 13 durch einen magnetisierten Bereich des zweiten Abdeckelements 6 auszubilden.

Das erste Abdeckelement 5 weist eine in den zweiten Teilaufnahmeraum 10 weisende Eintiefung 16 auf, in welcher sich das Magnetelement 13 in der ersten Stellung des zweiten Abdeckelements 6 befindet. Dazu greift der Vorsprung 15 in die Eintiefung 16 ein, wobei das zweite Abdeckelement 6 in der ersten Stellung auf dem ersten Abdeckelement 5 aufliegt.

Der Vorsprung 15 ist hier zweistückig mit einem Körper 15a des zweiten Abdeckelements 6 ausgebildet durch ein Befestigungsmittel 15b am Körper 15a befestigt. Alternativ ist es auch möglich, dass der Vorsprung 15 einstückig mit dem Körper 15a ausgebildet ist. Erkennbar ist auch, dass das erste Abdeckelement 5 auf seiner dem Aufnahmeraum 3 abgewandten Seite einen Rücksprung 17 aufweist, welcher einer Form des Körpers 15a des zweiten Abdeckelements 6 entspricht.

Der Magnetsensor 14 ist im zweiten Teilaufnahmeraum 10 angeordnet. Vorliegend ist der Magnetsensor 14 auf einer Leiterplatte 18, auf welcher ein Teil der elektrischen Komponenten der Einrichtung 1 montiert sind, angeordnet. Durch den Vorsprung 15 und die Eintiefung 16 kann dabei die Anordnung der Sensoreinheit 12 an eine Montagehöhe der Leiterplatte 18 im Aufnahmeraum 3 angepasst werden. Die Sensoreinheit 12 ist somit derart ausgebildet, dass mittels des Magnetsensors 14 eine Feldstärke des das erste Abdeckelement 5 durchdringenden Magnetfelds des Magnetelements 13 in der ersten Stellung des zweiten Abdeckelements 6 als Anwesenheit des Magnetelements 13 erfassbar ist.

Wieder mit Bezug zu Fig. 1 ist zu erkennen, dass im ersten Teilaufnahmeraum 9 ein Befestigungsmittel 19 zur lösbaren Befestigung einer elektrischen Komponente, hier einer Sicherung (nicht gezeigt), angeordnet ist. Bei der im ersten Teilaufnahmeraum 9 angeordneten Komponente handelt es sich generell um eine wartungsintensive Komponente, auf die häufiger ein Zugriff in einem Servicefall erforderlich ist als auf Komponenten, die im zweiten Teilaufnahmeraum 10 angeordnet sind.

Exemplarisch ist die elektrische Einrichtung 1 im vorliegenden Ausführungsbeispiel als Wechselrichter ausgebildet, sodass im zweiten Teilaufnahmeraum 10 beispielsweise Stromschienen 20 einer Gleichspannungsseite des Wechselrichters angeordnet sind. Bei den auf der Leiterplatte 18 angeordneten Komponenten handelt es sich teilweise um solche einer Steuereinrichtung des Wechselrichters. Auf die Komponenten im zweiten Teilaufnahmeraum 10 ist in der Regel kein Zugriff zur Wartung erforderlich, sodass die Detektion einer Überführung der Abdeckvorrichtung 4 aus der ersten Position in die zweite Position im Wesentlichen dazu dient, einen unberechtigten oder unbeabsichtigten Zugriff auf Hochvoltkomponenten, wie die Stromschienen 20, zu erfassen.

Die Einrichtung 1 umfasst ferner ein erstes Dichtelement 21, welches zum Abdichten des Gehäuses 2 gegenüber dem ersten Abdeckelement 5 ausgebildet ist. Bei diesem Dichtelement handelt es sich um eine Klebedichtung, die nicht zerstörungsfrei aus der ersten Position der Abdeckvorrichtung 4 in deren zweite Position überführbar ist. Allerdings lässt sich durch die Klebedichtung eine geforderte IP-Schutzklasse aufwandsarm und wirkungsvoll realisieren. Im Hinblick darauf, dass im zweiten Teilaufnahmeraum 10 ohnehin nur wartungsarme Komponenten angeordnet sind, ist ein Entfernen der gesamten Abdeckvorrichtung 4 im Servicefall ohnehin gar nicht vorgesehen.

Fig. 3 ist eine perspektivische Ansicht des zweiten Abdeckelements 6 mit Blick auf seine dem ersten Abdeckelement 5 zugewandte Seite.

Neben dem Vorsprung 15 mit dem Magnetelement 13 und dem Körper 15a ist ferner eine am zweiten Abdeckelement 6 bzw. seinem Körper 15a angeordnete Befestigungslasche 15c, die winklig vom Körper 15a absteht, gezeigt. Außerdem ist ein am zweiten Abdeckelement 6 bzw. seinem Körper 15a angeordnetes zweites Dichtelement 22 der Einrichtung 1 gezeigt.

Das zweite Dichtelement 22 ist zum Abdichten des ersten Abdeckelements 5 gegenüber dem zweiten Abdeckelement 6 ausgebildet und zerstörungsfrei aus der ersten Stellung des zweiten Abdeckelement 6 in dessen zweite Stellung überführbar. Vorliegend ist das zweite Dichtelement 22 als Silikondichtung ausgebildet und nur am zweiten Abdeckelement 6 befestigt. Folglich ist das zweite Dichtelement 22 im Gegensatz zum ersten Dichtelement 21 reversibel. Erkennbar erstreckt sich das zweite Dichtelement 22 in der ersten Stellung vom die Ausnehmung 7, sodass sich das Magnetelement 13 außerhalb eines Dichtbereichs des zweiten Dichtelement 22 befindet. Alternativ kann vorgesehen sein, dass sich das zweite Dichtelement 22 entlang einer Außenkontur des zweiten Abdeckelements 6 erstreckt.

In weiteren Ausführungsbeispielen ist das zweite Dichtelement 22 als O-Ring ausgebildet. Es kann auch ein weiteres Dichtelement vorgesehen sein, welches sich am zweiten Abdeckelement 6 oder am ersten Abdeckelement 5 um das Magnetelement 13 herum erstreckt, um dieses vor Korrosion zu schützten.

Fig. 4 ist ein Blockschaltbild einer Interlockschaltung 23 der Einrichtung 1.

Die Interlockschaltung 23 umfasst eine Steuereinheit 24, die dazu eingerichtet ist, die elektrischen Komponenten in Abhängigkeit des Detektionssignals 25 des Magnetsensors 14 spannungsfrei zu schalten. Dazu weist die Interlockschaltung 23 eine Schalteinheit 26 auf, die durch die Steuereinheit 24 ansteuerbar und dazu eingerichtet ist, eine elektrische Verbindung zu den elektrischen Komponenten in Abhängigkeit eines Steuersignals 27 der Steuereinheit 24 spannungsfrei zu schalten.

Die Interlockschaltung 23 umfasst eine eine Versorgungsspannung 28 des Magnetsensors 14 führende Leitung 29, auf welche hier ebenfalls das Detektionssignals 25 übertragen wird. Daneben ist bei der Interlockschaltung 23 eine Leiterschleife 30 vorgesehen, in welche ein Schaltelement 31 geschaltet ist. Das Schaltelement 31 ist dazu eingerichtet, die Leiterschleife 30 in Abhängigkeit des Detektionssignals 20 zu unterbrechen und zu schließen. Dabei wird aus einer Unterbrechung der Leiterschleife 30 auf eine Entfernung der Abdeckvorrichtung 4 vom Gehäuse 2, also auf eine Überführung aus ersten Position in zweite Position, oder auf eine Entfernung des zweiten Abdeckelements 6, also eine Überführung aus der ersten Stellung in die zweite Stellung, geschlossen. D. h., dass die Steuereinheit 24 bei einer Unterbrechung der Leiterschleife 30 das Steuersignal 27 ausgibt. In die Leiterschleife 30 können weitere Schaltelemente 31 oder kontaktbehaftete Leiterbrücken für die Überwachung anderer Orte der Einrichtung 1 im Hinblick auf ein unbefugtes oder unbeabsichtigtes Öffnen einer Abdeckung geschaltet sein.

Außerdem weist Interlockschaltung 23 eine Leitungsüberwachung 32 auf, welche dazu eingerichtet ist, die elektrischen Komponenten in Abhängigkeit eines eine Unterbrechung der Versorgungsspannung anzeigenden Überwachungssignals 33 spannungsfrei zu schalten. Dazu erfasst die Steuereinheit 24 einen Abfall einer Spannung auf der Leitung 29 und gibt in diesem Fall ebenfalls das Steuersignal 27 aus. Da so ein Ausfall des Magnetsensors 14 erkennbar ist, erfüllt die Interlockschaltung 23 ein Sicherheitsniveau gemäß ASIL B.

Fig. 4 zeigt ferner eine Diagnosefunktion 34 der Leitungsüberwachung 32, die einen durch die Steuereinheit 24 ansteuerbares Schaltelement 35 aufweist. Durch das Schaltelement 35 ist die Leitung 29 zu Diagnosezwecken der Leitungsüberwachung 32 gegen Masse schaltbar ist.

Gemäß einem weiteren Ausführungsbeispiel, bei dem zur Realisierung eines Sicherheitsniveaus entsprechend ASIL B auf die Leitungsüberwachung 32 verzichtet werden kann, umfasst die Sensoreinheit 12 einen redundanten Magnetsensor. Dieser stellt beim Detektieren einer Abwesenheit des Magnetelements 13 ein weiteres Detektionssignal bereit. Dazu kann die Interlockschaltung 23 beispielsweise ein weiteres Schaltelement aufweisen, das in Reihe mit dem Schaltelement 31 in die Leiterschleife 30 geschaltet ist und diese in Abhängigkeit des weiteren Detektionssignals trennt. So wird sichergestellt, dass die Komponenten bereits beim Vorliegen eines Detektionssignals eines der beiden Magnetelemente spannungsfrei geschaltet werden.

Fig. 5 ist eine Prinzipskizze eines Ausführungsbeispiels eines Fahrzeugs 38, das ein Ausführungsbeispiel einer Anordnung 36 mit einer elektrischen Maschine 37 und einer elektrischen Einrichtung 1 gemäß einem der zuvor beschriebenen Ausführungsbeispiele umfasst. Die Einrichtung 1 ist als Wechselrichter ausgebildet, der zur Bereitstellung einer, hier dreiphasigen, Wechselspannung für die elektrische Maschine 37 eingerichtet ist. Die elektrische Maschine 37 ist zum Antreiben des Fahrzeugs 38, beispielsweise eines Elektrofahrzeugs (BEV) oder eines Hybridfahrzeugs, eingerichtet.

## Patentansprüche

1. Elektrische Einrichtung (1), umfassend
- ein Gehäuse (2) mit einem Aufnahmeraum (3), in dem elektrische Komponenten der Einrichtung (1) angeordnet sind;
- eine Abdeckvorrichtung (4) mit einem ersten Abdeckelement (5) und einem zweiten Abdeckelement (6), wobei das erste Abdeckelement (5) eine Ausnehmung (7) aufweist und das zweite Abdeckelement (6) bezüglich des ersten Abdeckelements (5) derart anordenbar ist, dass das zweite Abdeckelement (6) in einer ersten Stellung die Ausnehmung (7) verdeckt und in einer zweiten Stellung einen Zugriff auf die Ausnehmung (7) ermöglicht, wobei die Abdeckvorrichtung (4) bezüglich des Gehäuses (2) derart anordenbar ist, dass die Abdeckvorrichtung (4) in einer ersten Position den Aufnahmeraum (3) verschließt, wenn das zweite Abdeckelement (6) in der ersten Stellung ist, und einen Zugriff auf einen ersten Teilaufnahmeraum (9) des Aufnahmeraums (3) durch die Ausnehmung (7) ermöglicht und einen zweiten Teilaufnahmeraum (10) des Aufnahmeraums (3) verschließt, wenn das zweite Abdeckelement (6) in der zweiten Stellung ist, und dass die Abdeckvorrichtung (4) in einer zweiten Position einen Zugriff auf den ersten Teilaufnahmeraum (9) und den zweiten Teilaufnahmeraum (10) ermöglicht; und
- eine Sensoreinheit (12) mit einem Magnetelement (13) und einem Magnetsensor (14), der dazu eingerichtet ist, beim Detektieren einer Abwesenheit des Magnetelements (13) ein Detektionssignal (25) bereitzustellen, wobei die Sensoreinheit (12) zum Detektieren der Abwesenheit des Magnetelements (13) in der zweiten Stellung des zweiten Abdeckelements (6) und in der zweiten Position der Abdeckvorrichtung (4) angeordnet und ausgebildet ist.

2. Einrichtung nach Anspruch 1, wobei
das Magnetelement (13) an dem oder im zweiten Abdeckelement (6) angeordnet ist.

3. Einrichtung nach Anspruch 1 oder 2, wobei
die Sensoreinheit (12) derart ausgebildet ist, dass mittels des Magnetsensors (14) eine Feldstärke des das erste Abdeckelement (5) durchdringenden Magnetfelds des Magnetelements (13) in der ersten Stellung des zweiten Abdeckelements (6) als Anwesenheit des Magnetelements erfassbar ist.

4. Einrichtung nach einem der vorhergehenden Ansprüche, wobei
das erste Abdeckelement (5) eine zum Aufnahmeraum (3) weisende Eintiefung (16) aufweist, in welcher sich das Magnetelement (13) in der ersten Stellung des zweiten Abdeckelements (6) befindet.

5. Einrichtung nach einem der vorhergehenden Ansprüche, wobei
der Magnetsensor (14) im Aufnahmeraum (3), vorzugsweise im zweiten Teilaufnahmeraum (10), angeordnet ist.

6. Einrichtung nach einem der vorhergehenden Ansprüche, wobei
im ersten Teilaufnahmeraum (9) ein Befestigungsmittel (19) zur lösbaren Befestigung einer der elektrischen Komponenten, vorzugsweise einer Sicherung, angeordnet ist.

7. Einrichtung nach einem der vorhergehenden Ansprüche, ferner umfassend ein Dichtelement (21), welches zum Abdichten des Gehäuses (2) gegenüber dem ersten Abdeckelement (5) ausgebildet ist und vorzugsweise nicht zerstörungsfrei aus der ersten Position in die zweite Position überführbar ist.

8. Einrichtung nach einem der vorhergehenden Ansprüche, ferner umfassend ein Dichtelement (22), welches zum Abdichten des ersten Abdeckelements (5) gegenüber dem zweiten Abdeckelement (6) ausgebildet und vorzugsweise zerstörungsfrei aus dessen erster Stellung in die zweite Stellung überführbar.

9. Einrichtung nach Anspruch 8, wobei
das Magnetelement (13) und der Magnetsensor (14) außerhalb eines Dichtbereichs des Dichtelements (22) angeordnet sind.

10. Einrichtung nach einem der vorhergehenden Ansprüche, wobei
die Sensoreinheit (12) ferner einen redundanten Magnetsensor aufweist, welcher dazu eingerichtet ist, beim Detektieren der Abwesenheit des Magnetelements (13) ein weiteres Detektionssignal bereitzustellen.

11. Einrichtung nach einem der vorhergehenden Ansprüche, ferner umfassend eine Interlockschaltung (23), welche dazu eingerichtet ist, die elektrischen Komponenten in Abhängigkeit des Detektionssignals (25) oder der Detektionssingale spannungsfrei zu schalten.

12. Einrichtung nach Anspruch 11, wobei
die Interlockschaltung (23) eine Leitungsüberwachung (32) für eine eine Versorgungsspannung (28) der Sensoreinheit (12) führende Leitung (29) aufweist und dazu eingerichtet ist, die elektrischen Komponenten in Abhängigkeit eines eine Unterbrechung der Versorgungsspannung (28) anzeigenden Überwachungssignals (33) der Leitungsüberwachung (32) spannungsfrei zu schalten.

13. Einrichtung nach einem der vorhergehenden Ansprüche, welche als Stromrichter, vorzugsweise als Wechselrichter, ausgebildet ist.

14. Anordnung (36) mit einer elektrischen Maschine (37) und einer Einrichtung (1) nach Anspruch 13, wobei der Stromrichter dazu eingerichtet ist, eine ein- oder mehrphasige Wechselspannung für die elektrische Maschine (37) bereitzustellen.

15. Fahrzeug (38), umfassend eine Einrichtung (1) nach einem der Ansprüche 1 bis 13 oder eine Anordnung (36) nach Anspruch 14.

## Claims

1. Electrical device (1), comprising
- a housing (2) having a receptacle space (3) in which electrical components of the device (1) are disposed;
- a cover device (4) having a first cover element (5) and a second cover element (6), wherein the first cover element (5) has a clearance (7), and the second cover element (6) is able to be disposed relative to the first cover element (5) in such a manner that the second cover element (6) in a first position covers the clearance (7), and in a second position enables access to the clearance (7), wherein the cover device (4) is able to be disposed relative to the housing (2) in such a manner that the cover device (4) in a first position closes the receptacle space (3) when the second cover element (6) is in the first position and enables access to a first partial receptacle space (9) of the receptacle space (3) via the clearance (7), and closes a second partial receptacle space (10) of the receptacle space (3) when the second cover element (6) is in the second position, and that the cover device (4) in a second position enables access to the first partial receptacle space (9) and the second partial receptacle space (10); and
- a sensor unit (12) having a magnetic element (13) and a magnetic sensor (14) which, when detecting an absence of the magnetic element (13), is specified to provide a detection signal (25), wherein the sensor unit (12) is disposed and designed to detect the absence of the magnetic element (13) in the second position of the second cover element (6) and in the second position of the cover device (4).

2. Device according to Claim 1, wherein
the magnetic element (13) is disposed on or in the second cover element (6).

3. Device according to Claim 1 or 2, wherein
the sensor unit (12) is designed in such a manner that in the first position of the second cover element (6) a field intensity of the magnetic field of the magnetic element (13) that penetrates the first cover element (5) is detectable by means of the magnetic sensor (14) as a presence of the magnetic element.

4. Device according to one of the preceding claims, wherein
the first cover element (5) has a depression (16) which points towards the receptacle space (3) and in which the magnetic element (13) is located in the first position of the second cover element (6).

5. Device according to one of the preceding claims, wherein
the magnetic sensor (14) is disposed in the receptacle space (3), preferably in the second partial receptacle space (10).

6. Device according to one of the preceding claims, wherein
a fastening means (19) for releasably fastening one of the electrical components, preferably a fuse, is disposed in the first partial receptacle space (9).

7. Device according to one of the preceding claims, furthermore comprising a sealing element (21) which is designed to seal the housing (2) in relation to the first cover element (5) and is preferably not able to be transferred from the first position to the second position in a non-destructive manner.

8. Device according to one of the preceding claims, furthermore comprising a sealing element (22) which is designed to seal the first cover element (5) in relation to the second cover element (6) and is preferably able to be transferred from its first position to the second position in a non-destructive manner.

9. Device according to Claim 8, wherein
the magnetic element (13) and the magnetic sensor (14) are disposed outside a sealing region of the sealing element (22).

10. Device according to one of the preceding claims, wherein
the sensor unit (12) furthermore has a redundant magnetic sensor which, when detecting the absence of the magnetic element (13), is specified to provide a further detection signal.

11. Device according to one of the preceding claims, furthermore comprising an interlocking circuit (23) which is specified to de-energize the electrical components as a function of the detection signal (25) or of the detection signals.

12. Device according to Claim 11, wherein
the interlocking circuit (23) has a line monitor (32) for a line (29) conducting a supply voltage (28) of the sensor unit (12), and is specified to de-energize the electrical components as a function of a monitor signal (33) of the line monitor (32) indicating an interruption of the supply voltage (28).

13. Device according to one of the preceding claims, said device being designed as a rectifier, preferably as an inverter.

14. Assembly (36) having an electric machine (37) and a device (1) according to Claim 13, wherein the rectifier is specified to provide a single-phase or multi-phase AC voltage for the electric machine (37).

15. Vehicle (38), comprising a device (1) according to one of Claims 1 to 13, or an assembly (36) according to Claim 14.

## Revendications

1. Dispositif électrique (1), comprenant
- un boîtier (2), pourvu d'un espace de réception (3) dans lequel sont disposés des composants électriques du dispositif (1) ;
- un système de recouvrement (4), pourvu d'un premier élément de recouvrement (5) et d'un deuxième élément de recouvrement (6), le premier élément de recouvrement (5) possédant une cavité (7) et le deuxième élément de recouvrement (6) pouvant être disposé par rapport au premier élément de recouvrement (5) de telle sorte que le deuxième élément de recouvrement (6) recouvre la cavité (7) dans une première position et rend possible un accès à la cavité (7) dans une deuxième position, le système de recouvrement (4) pouvant être disposé par rapport au boîtier (2) de telle sorte que le système de recouvrement (4), dans une première position, ferme l'espace de réception (3) lorsque le deuxième élément de recouvrement (6) se trouve dans la première position, et rend possible un accès à un premier espace de réception partiel (9) de l'espace de réception (3) à travers la cavité (7) et ferme un deuxième espace de réception partiel (10) de l'espace de réception (3), lorsque le deuxième élément de recouvrement (6) se trouve dans la deuxième position, et le système de recouvrement (4), dans une deuxième position, rend possible un accès au premier espace de réception partiel (9) et au deuxième espace de réception partiel (10) ; et
- une unité de capteur (12) pourvue d'un élément magnétique (13) et d'un capteur magnétique (14), qui est conçu pour fournir un signal de détection (25) lors de la détection d'une absence de l'élément magnétique (13), l'unité de capteur (12) étant disposée et configurée pour détecter l'absence de l'élément magnétique (13) dans la deuxième position du deuxième élément de recouvrement (6) et dans la deuxième position du système de recouvrement (4) .

2. Dispositif selon la revendication 1,
l'élément magnétique (13) étant disposé sur ou dans le deuxième élément de recouvrement (6).

3. Dispositif selon la revendication 1 ou 2,
l'unité de capteur (12) étant configurée de telle sorte qu'une intensité de champ du champ magnétique de l'élément magnétique (13) traversant le premier élément de recouvrement (5) dans la première position du deuxième élément de recouvrement (6) peut être détectée en tant que présence de l'élément magnétique au moyen du capteur magnétique (14) .

4. Dispositif selon l'une des revendications précédentes,
le premier élément de recouvrement (5) possédant un renfoncement (16) orienté vers l'espace de réception (3), dans lequel se trouve l'élément magnétique (13) dans la première position du deuxième élément de recouvrement (6).

5. Dispositif selon l'une des revendications précédentes,
le capteur magnétique (14) étant disposé dans l'espace de réception (3), de préférence dans le deuxième espace de réception partiel (10).

6. Dispositif selon l'une des revendications précédentes,
un moyen de fixation (19) destiné à la fixation amovible d'un des composants électriques, de préférence un fusible, étant disposé dans le premier espace de réception partiel (9).

7. Dispositif selon l'une des revendications précédentes, comprenant en outre un élément d'étanchéité (21), lequel est configuré pour réaliser l'étanchéité du boîtier (2) par rapport au premier élément de recouvrement (5) et, de préférence, ne peut pas être transféré de manière non destructive de la première position à la deuxième position.

8. Dispositif selon l'une des revendications précédentes, comprenant en outre un élément d'étanchéité (22), lequel est configuré pour réaliser l'étanchéité du premier élément de recouvrement (5) par rapport au deuxième élément de recouvrement (6) et, de préférence, ne peut pas être transféré de manière non destructive de sa première position à la deuxième position.

9. Dispositif selon la revendication 8,
l'élément magnétique (13) et le capteur magnétique (14) étant disposés à l'extérieur d'une zone d'étanchéité de l'élément d'étanchéité (22).

10. Dispositif selon l'une des revendications précédentes,
l'unité de capteur (12) possédant en outre un capteur magnétique redondant, lequel est conçu pour fournir un signal de détection supplémentaire lors de la détection de l'absence de l'élément magnétique (13).

11. Dispositif selon l'une des revendications précédentes, comprenant en outre un circuit d'interverrouillage (23), lequel est conçu pour mettre hors tension les composants électriques en fonction du signal de détection (25) ou des signaux de détection.

12. Dispositif selon la revendication 11,
le circuit d'interverrouillage (23) possédant une surveillance (32) de ligne pour une ligne (29) conduisant une tension d'alimentation (28) à l'unité de capteur (12) et étant conçu pour mettre hors tension les composants électriques en fonction d'un signal de surveillance (33) de la surveillance (32) de ligne, indiquant une interruption de la tension d'alimentation (28).

13. Dispositif selon l'une des revendications précédentes, lequel est réalisé sous la forme d'un convertisseur de courant, de préférence d'un onduleur.

14. Arrangement (36) comprenant une machine électrique (37) et un dispositif (1) selon la revendication 13, le convertisseur de courant étant conçu pour fournir une tension alternative monophasée ou polyphasée à la machine électrique (37).

15. Véhicule (38), comprenant un dispositif (1) selon l'une des revendications 1 à 13 ou un arrangement (36) selon la revendication 14.
